# EUROPEAN PATENT APPLICATION

(11) **EP 4 601 427 A1**
(43) Date of publication of application: **13.08.2025**
(21) Application number: 24156577.9
(22) Date of filing: 08.02.2024
(51) Int. Cl.: H05K 7/20, F24F 13/08

(54) **VENTILATION PANEL**

(71) Applicant: ABB E-mobility B.V., 2629 JG Delft (NL)
(72) Inventor: FONDELLI, Tommaso, 50063 Firenze (IT); FABBRINI, Marco, 52100 Arezzo (IT); SEMBOLONI, Alessandro, 52019 Laterina Pergine Valdarno (IT)
(74) Representative: Zimmermann & Partner Patentanwälte mbB

(57) **Abstract**

The invention relates to a ventilation panel (1) for a charging station, particularly an electric vehicle charging station, wherein the ventilation panel (1) comprises a louver support (50), and a plurality of louver blades (52) supported by the louver support (50), wherein the louver blades (52) have a sheet-like shape with a downstream trailing edge portion (56) and an upstream leading edge portion (54), wherein the louver blades (52) have a bent shape in a cross-sectional side view, wherein the louver blades (52) are supported such that the louver blades (52) define a louver plane (P) and a normal direction (N) being orthogonal to the louver plane (P), and that in the cross-sectional side view, the upstream leading edge portion (54) defines a smaller angle with respect to the normal direction (N) than the downstream trailing edge portion (56).

## Description

### Technical Field

The invention relates to a ventilation panel.

### Background

The continuous growth in the power density of electric vehicle (EV) charging station is making anything than negligible the charger power losses, therefore the resulting heat must be dissipated through a devoted cooling system. The air cooling is the standard solution selected by the different charging station producers, mainly because it is cheaper compared with liquid or two-phase cooling solutions. Unfortunately, the increase of power density requires an increase of air volume flow rate to guarantee the same thermal performance; that means increase the fans numbers or increasing the fans speed, leading, in any case, to higher acoustic noise, that is in contrast with the current market demand, asking for silent solutions.

Air cooling solutions require that the charger has at least an inlet for the fresh air and an outlet for the exhaust air, namely have ventilations panels that must fulfil several requirements, including:
- Guarantee a proper IP (ingress protection) rating (e.g. IP 54 rating, or IP 55 rating)
- Guarantee a proper IK (impact protection) rating (e.g. guarantee at least IK8 mechanical protection degree)
- Allow sufficient air flow rate for power electronic cooling
- Guarantee proper EMI shielding (if the class of the power electronic device is non-sufficient for the standard)
- Withstand to weather and direct exposure to sun radiation
- Meet the flammability requirement (UL 94), at least the part of the ventilation panel closer to the heat sources
- Must be cheap enough to make the solution applicable in the final product.

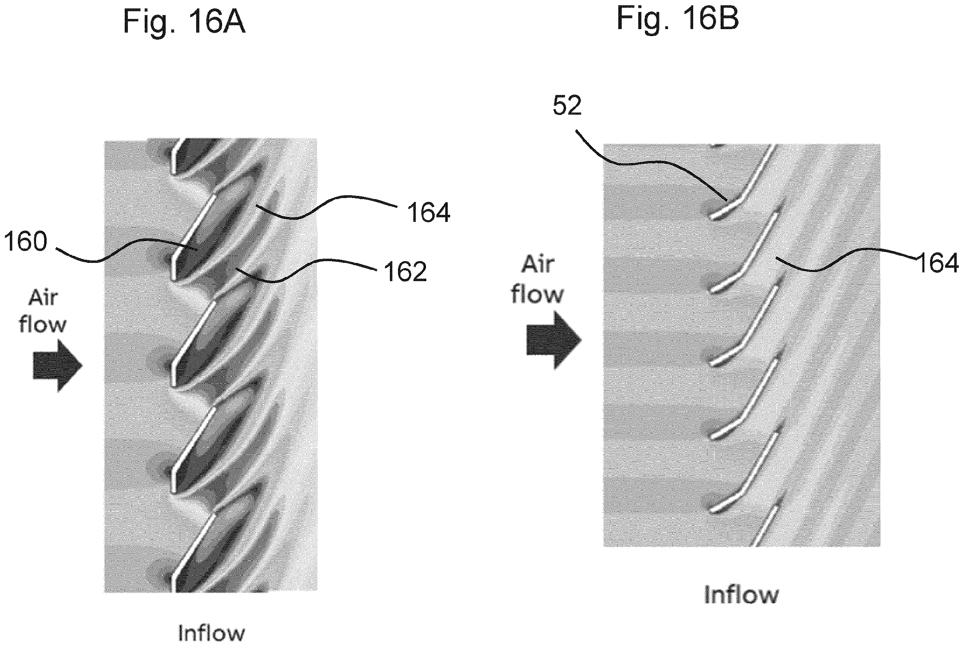

Solution for air ventilation panels employed in EV chargers exist that consist of a steel louver coupled with a filter media. The louver can offer protection against rain, wind, insects, as well as some electromagnetic interference (EMI) shielding; the dust capturing is demanded to the filter media, which moreover must catch the water (jets or droplets) passed by the louver. The IP rating of the ventilation panel is dependent on those parts, and how they are joined. Such a solution is cheap and suitable when airflow velocity through the louver is low, but as soon as the airflow increase, the resulting pressure losses impact significantly the thermal performance of the power electronics (also see Fig. 16A).

There is a need to provide a ventilation panel with improved properties such as improved usage of the filter.

### Disclosure of the invention

The problem is solved by the ventilation panel according to claim 1 and the charging station comprising a ventilation panel according to the invention. Further embodiments of these aspects of the present invention are stated in the corresponding sub claims and/or are described below.

A first aspect of the invention relates to a ventilation panel for a charging station, particularly an electric vehicle charging station. The ventilation panel comprises a louver support, and a plurality of louver blades supported by the louver support. The louver blades have a sheet-like shape with a downstream trailing edge portion and an upstream leading edge portion. The louver blades have a bent shape in a cross-sectional side view. The louver blades are supported by the louver support such that the louver blades define a louver plane and a normal direction being orthogonal to the louver plane, and that in the cross-sectional side view, the upstream leading edge portion defines a smaller angle with respect to the normal direction than the downstream trailing edge portion.

In an embodiment, the louver blades of the plurality of louver blades are arranged to span the louver plane. In an embodiment, the louver plane is spanned by a longitudinal extension direction of the louver blades and a distance between the louver blades perpendicular to the longitudinal direction. In an embodiment, the louver plane is spanned by the longitudinal extension direction of the louver blades and a height direction. The louver blades can be offset from each other in the height direction.

In an embodiment, all louver blades of the plurality of louver blades of the louver support have the same shape. In an embodiment, all louver blades of the plurality of louver blades of the louver support have the same size. In an embodiment, all louver blades of the plurality of louver blades of the louver support have the same size and the same shape.

The louver blades can be arranged parallel to each other. In an embodiment the louver blades are arranged such at the louver support that the longitudinal extension directions of the louver blades extend in parallel.

The leading edge portion can comprise a leading edge. The trailing edge portion can comprise a trailing edge. The leading edge can extend in the longitudinal extension direction of the respective louver blade. The trailing edge can extend in the longitudinal extension direction of the respective louver blade. In an embodiment, the leading edge and the trailing edge can extend in the longitudinal extension direction of the respective louver blade. In an embodiment, the leading edge and the trailing edge can extend in parallel.

In an embodiment, the louver blades have a curved shape in a cross-sectional side view. In an embodiment, the louver blades have an angled (buckled) shape in a cross-sectional side view. In an embodiment, the louver blades comprise a first section with a curved shape in a cross-sectional side view and a second section with an angled (buckled) shape in a cross-sectional side view.

In an embodiment, in the side view, the louver blade can have a partially curved shape. In an embodiment, in the side view, the louver blade can have a C-shape. In an embodiment, in the side view, the louver blade can have an arc-shape. In an embodiment, in the side view, the louver blade can have a fin-shape. In an embodiment, the louver blade can comprise a concavely curved section.

In an embodiment, in the side view, the leading edge portion is smaller than the trailing edge portion.

The leading edge portion can enclose an acute angle with respect to the normal direction of the louver plane. The leading edge portion can enclose an angle between 0° and 75°, particularly between 0° and 60°, particularly between 0° and 45°, with respect to the normal direction of the louver plane.

The trailing edge portion can enclose an acute angle with respect to the normal direction of the louver plane. The trailing edge portion can enclose an angle between 10° and 90°, particularly between 20° and 85°, particularly between 40° and 80°, with respect to the normal direction of the louver plane.

In an embodiment, the leading edge portion can enclose an angle between 0° and 75° with respect to the normal direction of the louver plane, and the trailing edge portion can enclose an angle between 10° and 90° with respect to the normal direction of the louver plane. In an embodiment, the leading edge portion can enclose an angle between 0° and 60° with respect to the normal direction of the louver plane, and the trailing edge portion can enclose an angle between 20° and 85° with respect to the normal direction of the louver plane. In an embodiment, the leading edge portion can enclose an angle between 0° and 45° with respect to the normal direction of the louver plane, and the trailing edge portion can enclose an angle between 40° and 80° with respect to the normal direction of the louver plane. In an embodiment, the leading edge portion can enclose an angle of 30° with respect to the normal direction of the louver plane, and the trailing edge portion can enclose an angle of 73° with respect to the normal direction of the louver plane. The difference angle between the angles defined by the leading edge portion and the trailing edge portion can be 43°. In an embodiment, the leading edge portion and the trailing edge portion enclose an obtuse angle.

In an embodiment of louver blades with a curved shape in a cross-sectional side view, the respective angles can be considered with regard to the respective tangents and the normal direction of the louver plane.

The aerodynamic properties of the louver blades can advantageously be improved. An advantage can be that the separation of the air flow can be reduced. An advantage can be that the airflow can pass the louver blades more even. Advantageously, regions of low airflow velocity can be reduced.

In an embodiment, the louver blades are arranged along a height direction perpendicular to the normal direction, wherein a first louver blade and a neighbouring second louver blade are arranged and configured such that neighbouring pairs of louver blades overlap with each other in height direction.

In an embodiment, with respect to the height direction, the trailing edge of the first louver blade protrudes over the leading edge of the second louver blade.

In an embodiment, the louver blades comprise a first side edge connecting the leading edge and trailing edge, wherein the louver blades are mounted at the louver support by the first side edge.

In an embodiment, the louver blades comprise the first side edge and an opposing second side edge connecting the leading edge and trailing edge, wherein the louver blades are mounted at the louver support by the first side edge and the second side edge.

In an embodiment, the louver blades comprise the first side edge and the opposing second side edge connecting the leading edge and trailing edge, wherein the louver blades are mounted at the louver support only by the first side edge and the second side edge.

In an embodiment, the leading edge is unconnected to the louver support. In an embodiment, the trailing edge is unconnected to the louver support. In an embodiment, the connection between the louver blade and the louver support is provided, particularly only provided, by the first side edge and/or the second side edge.

An advantage can be that the aerodynamic properties of the louver support with attached louver blades can advantageously be improved. An advantage can be that the separation of the air flow can be reduced. An advantage can be that the airflow can pass the louver blades more even.

In an embodiment, the louver blades are rotatably mounted at the louver support. In an embodiment, the louver blades are rotatable (hingeable, tiltable). In an embodiment, the louver blades are repeatedly, reversibly rotatable between a working position and a closed position, wherein in the closed position the louver blades are set at a steeper angle than in the working position. In an embodiment, the louver blades are repeatedly, reversibly rotatable between a working position and a closed position such that in the closed position an air flow through the louver support is reduced.

In an embodiment, in the closed position, the trailing edge of a louver blade can touch the leading edge portion of the neighbouring louver blade. In an embodiment, in the closed position, the trailing edge of a louver blade can be adjacent to the leading edge portion of the neighbouring louver blade. In an embodiment, in the closed position, the trailing edge of a louver blade can be closer to the leading edge portion of the neighbouring louver blade than in the working position.

In an embodiment, the louver blades are rotatable around an axis extending parallel to the longitudinal extension direction of the louver blades.

In an embodiment, a working-angle of the louver blades can be adjusted by rotating the louver blades.

In an embodiment, the louver blades can be rotated in the closed position when the charging station is not in charging state. An advantage can be a reduction of the dust ingress. An advantage can be that the replacement time for the filter can be increased. Advantageously, when ambient temperature is cold, a higher temperature of the charger can be maintained. Advantageously, the power module reliability can be increased.

In an embodiment, the ventilation panel comprises a rotation actuation system. In an embodiment, the ventilation panel comprises a locking mechanism. In an embodiment, the locking mechanism can be configured to lock the louver blades in the working position. In an embodiment, the locking mechanism can be configured to repeatedly, reversible lock the louver blades in the working position. In an embodiment, the locking mechanism is configured to lock the louver blades in the closed position. In an embodiment, the locking mechanism is configured to repeatedly, reversible lock the louver blades in the closed position. In an embodiment, the locking mechanism is configured to repeatedly, reversible lock the louver blades in the closed position and configured to repeatedly, reversible lock the louver blades in the working position.

In an embodiment, the louver support comprises an interlocking structure, wherein the interlocking structure is configured such that a plurality of louver supports are attachable to each other thereby forming a one-dimensional or a two-dimensional array of interlocked louver supports.

In an embodiment, the interlocking structure is arranged and configured such that a first louver support is repeatedly, reversible assemblable to a further louver support via the interlocking structure of the louver support and a corresponding interlocking structure of the further louver support to generate the array of louver supports.

The louver supports each with the interlocking structure can allow a plurality of louver supports to be attached to each other thereby forming a one- or two-dimensional array of interlocked louver supports.

The interlocking structures of the louver supports can be configured to provide a horizontal assembly of two louver supports. The interlocking structures of the louver supports can be configured to provide a vertical assembly of two louver supports.

The interlocking structures of the louver supports can be configured such that the louver planes of the louver supports of the array of interlocked louver supports are arranged in a common louver plane.

An advantage can be that different sizes and/or shapes of arrays can be formed by a plurality of equal louver supports. The louver supports can be modules of a modular system which can easily be adapted (e.g. change of the size). The production process can advantageously be simplified. Production costs can advantageously be reduced.

An advantage can be that single louver supports of an allay of louver supports can be replaced. This can advantageously reduce the costs (e.g. reduce repair costs). Advantageously, resources can be saved.

According to an embodiment, the louver support can be used in the context of the inflow airflow. In an embodiment, the louver support can be used in the context of the outflow airflow. In an embodiment, in comparison to the inflow configuration, the louver support is rotated by 180° about the vertical axis.

An inflow of air (inflow airflow) can be that air from an external space, e.g. from the environment, flows into an interior space, e.g. an interior compartment of the charging station, particularly through the ventilation panel. The ventilation panel can be configured and arranged for use in an inflow configuration allowing (supporting) an inflow of air. Particularly, the ventilation panel can be configured and arranged such that air can flow from the external space via the ventilation panel into the interior space.

An out of air (outflow airflow) can be that air from an interior space, e.g. from the interior compartment of the charging station, flows into the external space, e.g. the environment, particularly through the ventilation panel. The ventilation panel can be configured and arranged for use in an outflow configuration allowing (supporting) an outflow of air. Particularly, the ventilation panel can be configured and arranged such that air can flow from the interior space via the ventilation panel into the external space.

Advantageously, louver supports can be used for inflow as well as outflow configuration. The production process can advantageously be simplified. Production costs can advantageously be reduced.

In an embodiment, the louver support comprises a plastic material. In an embodiment, the louver support consists of a plastic material. In an embodiment, the louver blades comprise a plastic material. In an embodiment, the louver blades consist of a plastic material. In an embodiment, the louver support and the louver blades comprise a plastic material. In an embodiment, the louver support and the louver blades consist of a plastic material. In an embodiment, the plastic material can be a mouldable plastic material. Advantageously, the production costs can be reduced. Advantageously, a plastic material may easily be formed in the particular sheet-like shape of the louver blades.

In an embodiment, the ventilation panel further comprises a filter arrangement. The filter arrangement can comprise a filter supported by a filter support. The filter can comprise a filter surface. The filter arrangement can be configured such that the filter surface is arrangeable essentially in parallel to the louver plane.

In an embodiment, the filter arrangement and the louver support are configured and arrangeable such that in an inflow configuration the trailing edge is closer to the filter, particularly the filter surface, than the leading edge.

In an embodiment, the filter arrangement and the louver support are configured and arrangeable such that in an outflow configuration the leading edge is closer to the filter than the trailing edge.

In an embodiment, the filter arrangement is configured and arrangeable such that the filter surface is arrangeable essentially in parallel to the louver plane, such that in the inflow configuration the filter surface is affectable by air flowing through the louver support.

In an embodiment, the filter arrangement is configured and arrangeable such that the filter surface is arrangeable essentially in parallel to the louver plane such that in an outflow configuration the louver support is reachable by air leaving the filter surface.

In an embodiment, the louver blade comprises an airflow-facing surface. In an embodiment, in the inflow configuration the airflow-facing surface faces away from the filter. In an embodiment, in the outflow configuration the airflow-facing surface faces towards the filter. In an embodiment, in the inflow configuration, the louver blade is arranged such that it is bent upwards (particularly from the leading edge towards the trailing edge). In an embodiment, in the outflow configuration, the louver blade is arranged such that it is bent downwards (particularly from the leading edge towards the trailing edge).

In an embodiment, in comparison to the inflow configuration, in the outflow configuration the louver support is rotated by 180° about a vertical axis of the louver support.

In an embodiment, depending on the orientation, the louver support can be used for the inflow configuration as well as for the outflow configuration. Advantageously, no installation of different louver supports for the different configurations (inflow/outflow) is necessary. Advantageously, the production can be simplified. Advantageously, the maintenance can be simplified.

In an embodiment, the filter can be a pleated filter.

In an embodiment, the distance between louver blades, particularly the trailing edge, and the filter (or filter surface) is between 0 mm and 5 mm, particularly between 0,5 mm and 3 mm. In an embodiment, the distance between louver blades and filter (or filter surface) is between 1 mm and 3 mm, particularly 2 mm. In an embodiment, the filter (or filter surface) is pushed against the louver blades.

In an embodiment, distance between louver blades, particularly the trailing edge, and the filter (or filter surface) is between 2 cm and 25 cm, particularly between 5 cm and 20 cm. In an embodiment, the distance between louver blades and filter (or filter surface) is between 7 cm and 15 cm, particularly between 9 cm and 12 cm, particularly 10 cm.

The filter support can comprise a filter frame. In an embodiment, the filter frame comprises plastic. In an embodiment, the filter frame consists of plastic. In an embodiment, the filter frame comprises metal. In an embodiment, the filter frame consists of metal.

In an embodiment, the filter arrangement can comprise the filter (the filtering media) and the frame.

In an embodiment, particularly with regard to the inflow (of air), the filter surface is arrangeable such that the filter surface is affectable by air flowing through the louver support.

In an embodiment, particularly with regard to the inflow (of air), the filter can be arranged downstream of the louver blades.

In an embodiment, particularly with regard to the outflow (of air), the filter surface is arrangeable such that air leaving the filter surface can flow through the louver support.

An advantage can be that the aerodynamic properties of the louver blades can advantageously be improved, such that a larger portion of the filter (filter surface) can be affected by the airflow (particularly the inflow). The filter properties can advantageously be improved. Advantageously, a larger area of the filter can be used. The efficiency can be improved.

In an embodiment, the filter arrangement comprises an outer perimeter, wherein the outer perimeter of the filter arrangement comprises a portion of the filter, wherein the outer perimeter of the filter arrangement is configured for sealing.

In an embodiment, the filter arrangement comprises an outer perimeter, wherein the outer perimeter of the filter arrangement comprises a portion of the filter support, wherein the outer perimeter of the filter arrangement is configured for sealing.

In an embodiment, the filter arrangement comprises an outer perimeter, wherein the outer perimeter of the filter arrangement comprises a portion of the filter and a portion of the filter support, wherein the outer perimeter of the filter arrangement is configured for sealing.

In an embodiment, the outer perimeter of the filter arrangement is configured for perimetric sealing.

In an embodiment, the sealing between the filter and the structural frame where it is installed is realized in the outer perimeter of the filter frame.

In an embodiment, the filter comprises a portion configured for sealing, particularly perimetric sealing. In an embodiment, the filter comprises a first portion (perimetric portion) configured for sealing, and a second portion (central portion) configured for filtering.

In an embodiment, the filter support comprises a portion configured for sealing, particularly perimetric sealing. In an embodiment, the filter support comprises a first portion configured for sealing, and a second portion configured for supporting the filter.

In an embodiment, the filter and/or the filter support has to guaranteed a perimetric sealing between the structural frame and the filter itself. In an embodiment of a filter solution where the filter protrudes outwards beyond the filter support, the filter can be this part to fulfil the sealing task. In an embodiment of a filter in which the perimetric part consist of the filter frame, then, a sealing means, e.g., a gasket, has to be installed on the perimeter to guarantee the sealing. In an embodiment, the filter frame comprises the sealing means.

In an embodiment, the filter support comprises a first filter frame and a corresponding second filter frame, wherein the first filter frame and the second filter frame are configured such that the first filter frame is assembleable to the second filter frame.

In an embodiment the first filter frame and the second filter frame are configured such that the filter is mechanically locked between the first filter frame and the second filter frame, when the first filter frame is assembled to the second filter frame.

In an embodiment, the first filter frame is repeatedly, reversible assembleable to the second filter frame.

In an embodiment, the filter support is configured such that it is easily disassembled. In an embodiment, the filter frames are easily disassembleable, to allow the recycling of all the part of which it is made. An advantage can be that environmental friendliness can be increased.

In an embodiment, the filter support is openable to allow the replacement of the filtering media only, that can be recycled.

Advantageously, the filter support, the filter frame and/or parts of filter support (or filter frame) can be re-used. Advantageously, resources can be saved. An advantage can be that environmental friendliness can be increased. In an embodiment, the filter can be recycled.

In an embodiment, the filter frame, particularly the plastic frame, comprises two parts (particularly the first filter frame and the second filter frame), where the filter media is installed between. In an embodiment, the two filter frames are compressed together and mechanically locked. In an embodiment, an easy disassemble can be enabled, advantageously enabling easy recycling. In an embodiment, the filter frame can be re-used.

The mechanical assembling of the filter can be done in several ways.

In an embodiment, the first filter frame and/or the second filter frame comprises a handle to easing the filter dismounting.

In an embodiment, the filter support comprises an attachment device, wherein the attachment device is arranged and configured to attach the filter to the filter support, wherein the attachment device is configured for single use.

In an embodiment, the attachment device comprises a meltable spike.

In an embodiment, the filter support comprises an attachment device, wherein the attachment device is arranged and configured to attach the filter to the filter support, wherein the attachment device is configured for repeated, reversible attachment.

In an embodiment, the attachment device comprises a magnet, particularly a plurality of magnets. The magnets can be arranged and configured such that the magnetic forces can keep the filter together. In an embodiment, the attachment device comprises a clip, particularly a plurality of clips. In an embodiment, the attachment device comprises a metal clip, particularly a plurality of metal clips. In an embodiment, the attachment device comprises a hinge. In an embodiment, the attachment device comprises a plurality of hinges. In an embodiment the hinged filter frame can be a permanent filter frame that can be opened and can accept filter replacement. Such a filter frame can be re-used. In an embodiment, the attachment device comprises a wire, particularly a plurality of wires. In an embodiment, the attachment device comprises a tongue, particularly a plurality of tongues. In an embodiment, the attachment device comprises a groove, particularly a plurality of grooves. In an embodiment, the attachment device comprises a plug, particularly a plurality of plugs. In an embodiment, the attachment device comprises a socket, particularly a plurality of sockets.

In an embodiment, the filter arrangement comprises an outer perimeter, wherein the filter protrudes outwards beyond the filter support when the filter is mechanically locked between the first filter frame and the second filter frame, such that the outer perimeter of the of the filter arrangement comprises the filter protruding outwards beyond the filter support.

In an embodiment, the filter protrudes radially outwards beyond the filter support when the filter is mechanically locked between the first filter frame and the second filter frame, such that the outer perimeter of the of the filter arrangement comprises the filter protruding outwards beyond the filter support.

In an embodiment, the filter support comprises a sealing means, particularly wherein the sealing means is arranged at the outer perimeter of the filter support, such that the outer perimeter of the of the filter arrangement comprises the filter support comprising the sealing means.

In an embodiment, the filter arrangement and the louver support are configured and arranged for the reduction of an intrusion of dust and/or liquids. In an embodiment, the filter arrangement and the louver support are configured and arranged such that an ingress protection is provided. In an embodiment, the filter arrangement and the louver support are configured and arranged such that an IP rating of IP54 is provided. In an embodiment, the filter arrangement and the louver support are configured and arranged such that an IP rating of IP55 is provided.

In an embodiment, the ventilation panel for a charging station further comprises a structural frame, wherein the structural frame comprises an outer surface and an inner surface, wherein the structural frame and the louver support are configured such that the louver support is arrangeable at the inner surface of the structural frame, particularly such that the louver plane is arrangeable parallel to the inner surface of the structural frame.

In an embodiment, the structural frame is removably installable in a ventilation opening of the charging station.

In an embodiment, the louver support is repeatedly, reversible arrangeable at the inner surface of the structural frame.

In an embodiment, the structural frame can comprise a metal frame.

In an embodiment, the structural frame comprises an interlocking structure and the louver support comprises a corresponding interlocking structure, wherein the interlocking structures are configured such that the louver support is repeatedly, reversibly assemblable to the structural frame.

In an embodiment, the structural frame comprises an interlocking structure and the louver support comprises a corresponding interlocking structure, wherein the interlocking structure of the structural frame and the interlocking structure of the louver support are configured such that the louver support is repeatedly, reversibly assemblable to the structural frame, via these interlocking structures.

In an embodiment, the interlocking structure of the structural frame and the interlocking structure of the louver support provide a clamping interlocking system.

In an embodiment, the installation of the louver support, particularly the plastic louver support, in the structural frame, particularly the metal structural frame, can be achieved by a clamping locking system. Advantageously, a fastening-device-free installation can be provided. In an embodiment, advantageously, no screws are needed. An advantage can be that no additional tools are needed for installation. The installation process can be simplified. Advantageously, maintenance can be simplified and/or accelerated.

In an embodiment, the structural frame comprises a metal front face, wherein the metal front face comprises a plurality of through-openings.

In an embodiment, the structural frame comprises a liquid collection container, wherein the liquid collection container is in fluid communication with an outlet.

In an embodiment, the structural frame is made of metal. In an embodiment, the metal front face is holed to allow the air passage. The diameter of the holes can affect the EMI shielding properties of the ventilation panel. In an embodiment, the connection between the structural frame and the plastic louver is not watertight. In an embodiment, the bottom part of the structural frame comprises a water catch tank (liquid collection container).

In an embodiment, the structural frame comprises a filter installation system. In an embodiment, the filter installation system is configured to receive the filter arrangement, particularly to receive the filter support with the supported filter. In an embodiment, the filter installation system is arranged and configured such that when the louver support is assembled to the structural frame and the filter arrangement is received by the filter installation system, the outer perimeter of the filter arrangement provides a sealing, particularly a perimetric sealing, between the structural frame and the filter. In an embodiment, the filter can fill the gap between the filter frame and the structural frame.

In an embodiment, the filter installation system is arranged and configured such that when the louver support is assembled to the structural frame, the filter is pressed against the louver support and/or against the louver blades, when the filter support with the supported filter is received by the filter installation system.

In an embodiment, when the filter arrangement is installed at the structural frame, the filter arrangement can be kept in position by a fastening system. In an embodiment, the fastening system can be located on the top region of the ventilation panel. In an embodiment, the fastening system can push the filter against the louver blades.

In an embodiment, the ventilation panel can comprise a plurality of aerodynamic louvers, particularly supported by a louver support. In an embodiment, the ventilation panel can comprise a filter, particularly a filter of a filter arrangement. In an embodiment, the ventilation panel can comprise a structural frame. The structural frame can be configured to receive the louver support. The structural frame can be configured to receive the filter arrangement. In an embodiment, the structural frame can be configured to receive the louver support and the filter arrangement.

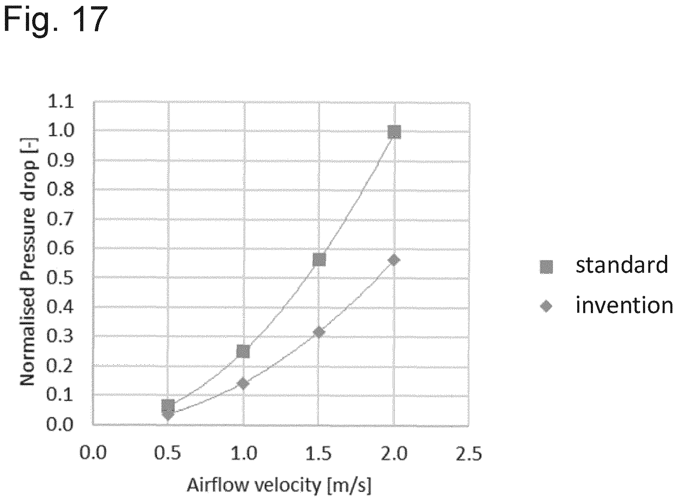

In an embodiment, the louver blades (aerodynamic louvers) can be configured to reduce (particularly minimise) the pressure loss (pressure drop) due to the louver (see, e.g., Fig. 17). In an embodiment, the louver blades can be configured to minimise the separation regions to allow the airflow to use the whole filter media surface (see, e.g., Fig. 16B). The louver blades can be configured such that the flow separation is prevented and the airflow velocity is reduced.

A louver blade can be used in inflow configuration. A louver blade can be used in outflow configuration. In an embodiment, the louver blade can reduce the pressure loss in inflow configuration. In an embodiment, the louver blade can reduce the pressure loss in outflow configuration.

In an embodiment, wherein the ventilation panel can comprise a louver support, and a plurality of louver blades supported by the louver support, wherein a louver blade of the plurality of louver blades, particularly each louver blade of the plurality of louver blades, has a sheet-like shape, wherein the louver blade comprises a downstream trailing edge portion of the louver blade and an upstream leading edge portion of the louver blade, wherein the louver blade has a bent shape in a cross-sectional side view, wherein the louver blade is configured and arranged and/or arrangeable such that the upstream leading edge portion of the louver blade is at a smaller angle to the normal direction than the downstream trailing edge portion.

In an embodiment, the louver support can comprise a front side of the louver support, wherein the front side of the louver support can define a virtual front plane, wherein the louver blades are configured and arranged and/or arrangeable such that the upstream leading edge portion of the louver blade and the virtual front plane enclose a larger angle than the downstream trailing edge portion of the louver blade and the virtual front plane. In an embodiment, the trailing edge portion can be steeper than the leading edge portion.

In an embodiment, the structural frame is configured and arranged for impact protection. In an embodiment, the structural frame is configured and arranged to provide a protection against external mechanical impacts. In an embodiment, the structural frame is configured and arranged to provide at least an IK8 mechanical protection degree.

In an embodiment, the structural frame, the filter arrangement and the louver support are configured and arranged for the reduction of an intrusion of dust and/or liquids. In an embodiment, the structural frame, the filter arrangement and the louver support are configured and arranged such that an ingress protection is provided. In an embodiment, the structural frame, the filter arrangement and the louver support are configured and arranged such that an IP rating of IP54 is provided. In an embodiment, the structural frame, the filter arrangement and the louver support are configured and arranged such that an IP rating of IP55 is provided.

In an embodiment, the ventilation panel can be configured and arranged for use in an inflow configuration allowing (supporting) an inflow of air. Particularly, the ventilation panel can be configured and arranged such that air can flow from the external space via the metal front face, via the louver support and via the filter arrangement into the interior space.

In an embodiment, the ventilation panel can be configured and arranged for use in an outflow configuration allowing (supporting) an outflow of air. Particularly, the ventilation panel can be configured and arranged such that air can flow from the interior space via the filter arrangement, via the louver support and via the metal front face into the external space.

A further aspect relates to a charging station comprising the ventilation panel according to the invention. The charging station can be a charging station for an electric vehicle.

In an embodiment, the ventilation panel is removably installable in a ventilation opening of the charging station. In an embodiment, the ventilation panel is repeatedly, reversibly removably installable in a ventilation opening of the charging station.

In an embodiment, the ventilation panel is arranged in the ventilation opening in the inflow configuration. In the inflow configuration, the filter can be arranged downstream of the louver support.

In an embodiment, the ventilation panel can be arranged at the charging station in the outflow configuration. In the outflow configuration, the filter can be arranged upstream of the louver support. In an embodiment, the charging station comprises a plurality of ventilation panels. In an embodiment, the charging station comprises a plurality of ventilation panels wherein a first ventilation panel of the plurality of ventilation panels is in inflow configuration and a second ventilation panel of the plurality of ventilation panels is in outflow configuration.

In an embodiment, in the inflow configuration, the louver blades are downstream of the metal front face of the structural frame and the filter is downstream of the louver blades. In an embodiment, in the outflow configuration, the louver blades are downstream of the filter and the metal front face of the structural frame is downstream of the louver blades.

In an embodiment, in comparison to the inflow configuration, in the outflow configuration, the louver support is rotated by 180° about the vertical axis.

A ventilation panel can be arranged in a side wall of the charging station.

The ventilation panel, particularly the plurality of ventilation panels, can be arranged such that air-cooling of the charging station is provided.

An advantage can be that the charging station can easily be maintained. Advantageously, this can safe time and/or resources. Further, the filter properties can advantageously be improved. Advantageously, the structural frame, the louver support and the filter arrangement can provide proper impact and/or ingress protection. Advantageously, a proper protection of the internal components (e.g. electrical or electronic components) of the charging station against mechanical impacts and/or liquids and/or dust can be provided while also providing a proper air cooling. The functioning of the charging station can advantageously be improved.

### Brief description of the drawings

Further features and embodiments of the present invention are described in the following with reference to the Figures, wherein:
- Fig. 1A: shows a schematic view of an embodiment of a ventilation panel in a fully assembled state,
- Fig. 1B: shows a schematic view of an embodiment of a ventilation panel in a disassembled state,
- Fig. 2A: shows a schematic perspective view of an embodiment of a louver support with supported louver blades,
- Fig. 2B: shows a schematic view of an embodiment of an array of louver supports,
- Fig. 3A: shows a schematic side view of an embodiment of a plurality of angled louver blades,
- Fig. 3B: shows a schematic side view of an embodiment of an angled louver blade,
- Fig. 4: shows a schematic side view of an embodiment of a curved louver blade,
- Fig. 5A: shows a schematic side view of an embodiment of a plurality of C-shaped louver blades,
- Fig. 5B: shows a schematic side view of an embodiment of a plurality of blade-shaped louver blades,
- Fig. 6A: shows an embodiment of an interlocking structure,
- Fig. 6B: shows an embodiment of an interlocking structure,
- Fig. 7A: shows a schematic side view of an embodiment of a structural frame and an embodiment of an associated louver support,
- Fig. 7B: shows a detail of Fig. 7A (upper part),
- Fig. 7C: shows a detail of Fig. 7A (lower part),
- Fig. 8A: shows a schematic side view of the arrange of the filter arrangement at the structural frame,
- Fig. 8B: shows a schematic side view of the arrange of the filter arrangement at the structural frame,
- Fig. 8C: shows a schematic side view of the arrange of the filter arrangement at the structural frame,
- Fig. 8D: shows a schematic view of an embodiment of a filter arrangement,
- Figs 9A, 9B: show a filter arrangement in the disassembled state,
- Fig. 10: shows a filter arrangement with a clip mechanism,
- Figs 11A, 11B: show a filter arrangement with a spike-and-hole-mechanism,
- Figs 12A, 12B: show a filter arrangement with a wire-mechanism,
- Figs 13A, 13B: show a filter arrangement with a magnet-mechanism,
- Figs 14A-C: show a filter arrangement with a hinged filter frame,
- Figs 15A, 15B: show a filter arrangement with a sealing at the filter support,
- Fig. 16A: shows a contour plot of air velocity through a standard louver, compute by CFD simulations,
- Fig. 16B: shows a contour plot of air velocity through a louver support according to the invention, compute by CFD simulations,
- Fig. 17: shows the normalized pressure drop across as a function of airflow velocity,
- Fig. 18: shows a scheme of an embodiment of a charging station.

### Detailed description of embodiments

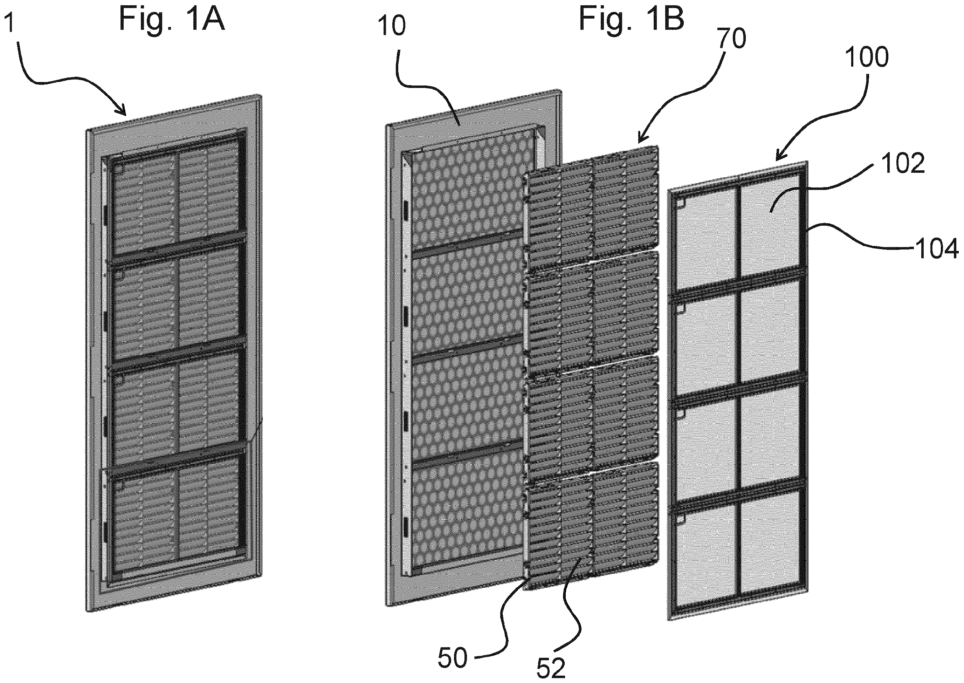

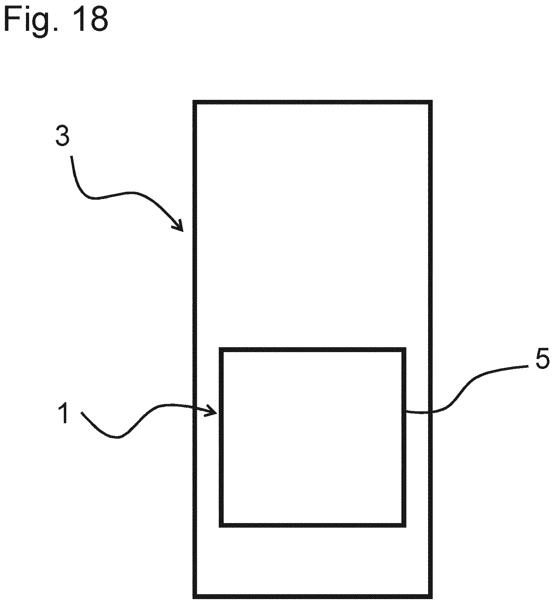

In Figure 1A, an embodiment of a ventilation panel 1 for a charging station 3 is illustrated in a fully assembled state. The ventilation panel 1 can be arranged in the ventilation opening 5 of the charging station 3 (see Fig. 18). In Figure 1B, the embodiment of Figure 1A is shown in a disassembled state. The illustrated ventilation panel 1 comprises a structural frame 10. The illustrated ventilation panel 1 comprises a louver support 50, particularly a plurality of louver supports 50, and a plurality of louver blades 52. A louver blade 52 of the plurality of louver blades can be supported by the louver support 50. In the illustrated example, an array 70 of eight louver supports 50 is shown (comprising four rows and two columns of louver supports 50). The illustrated ventilation panel 1 comprises a filter arrangement 100. The illustrated filter arrangement 100 comprises a filter 102 and a filter support 104. The filter support 104 can support the filter 102. The filter 102 can extend in a filter extension plane. In the fully assembled state (Fig. 1A) that louver support 50 and the filter arrangement 100 are attached to the structural frame 10.

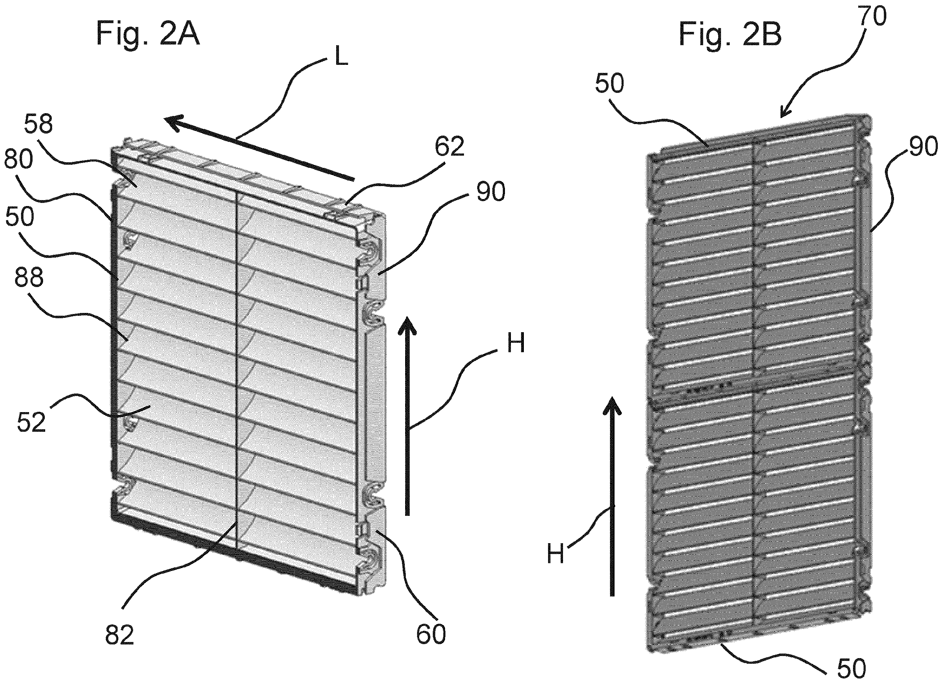

In Figure 2A, a louver support 50 is illustrated. The louver support 50 can comprise a louver support frame 80. The louver support 50 can comprise a plurality of louver blades 52. The plurality of louver blades 52 can be arranged in a louver blade area 53. The louver blade area 53 can be surrounded by the louver support frame 80.

The louver support 50 can support a plurality of louver blades 52, particularly a plurality of louver blades 52 of the same shape and/or size. In an embodiment, the louver support 50 can support a plurality of identical louver blades 52.

The louver support 50 can comprise an outer louver support frame 80. The louver support 50 can comprise a central louver support strut 82. The central louver support strut 82 can extend in a height direction H of the louver support 50. The louver support frame 80 of a louver support 50 can form an outer perimeter 90 (external border) of the louver support 50. The louver support frame 80 of a louver support 50 can extend in a circumferential direction of the louver support 50.

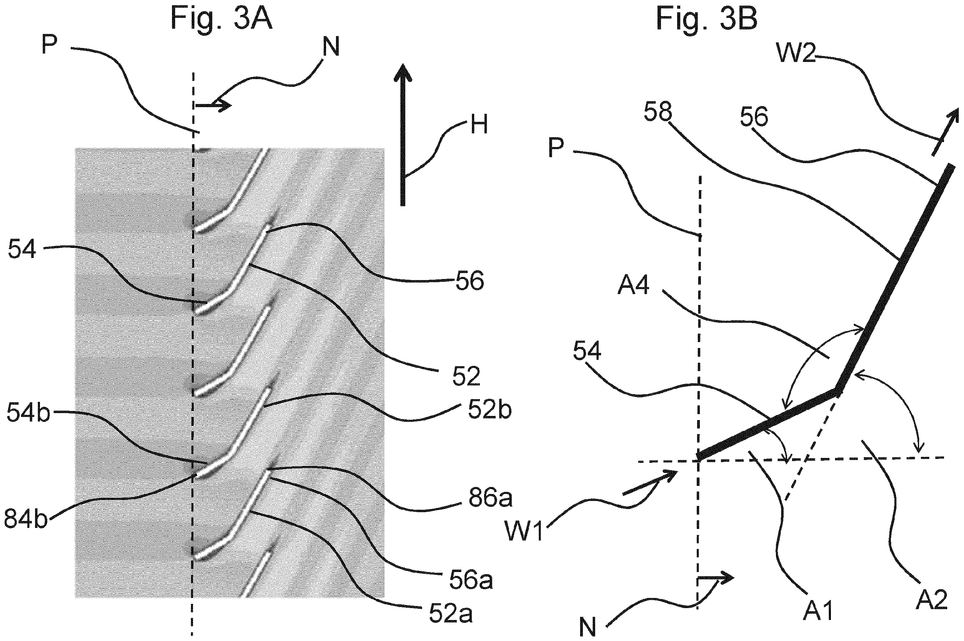

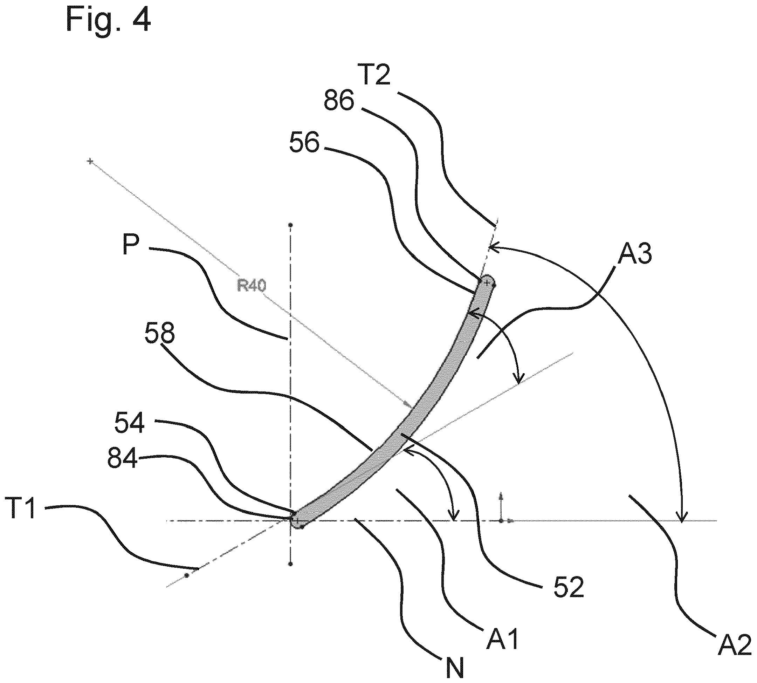

A louver blade 52 of the plurality of louver blades 52 can be arranged between the central louver support strut 82 and the outer louver support frame 80. In the illustrated embodiment, each louver blade 52 of the plurality of louver blades 52 can be arranged between the central louver support strut 82 and the outer louver support frame 80. The louver blades can comprise a first side edge 88. The louver blades 52 can be attached to the louver support 50 via the first side edge 88. The louver blades 52 can be arranged perpendicular to the height direction H. In the illustrated embodiment, the plurality of louver blades 52 is stacked at a distance from each other along the height direction H. The louver blades 52 can span a louver plane P (also see Figs 3A, 3B, 4).

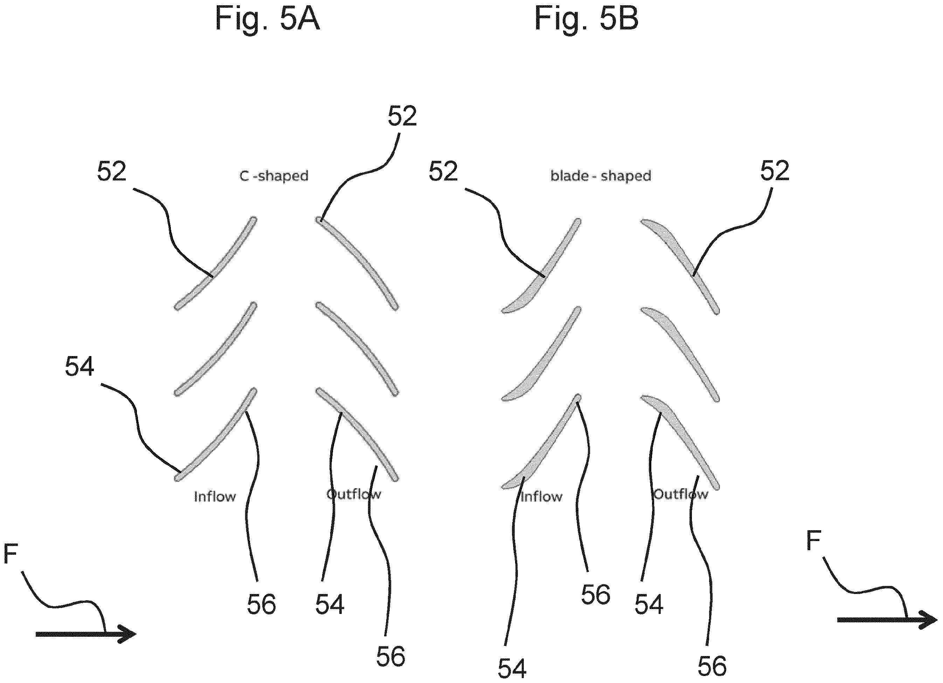

A louver blade 52 of the plurality of louver blades 52 can extend in the longitudinal extension direction L of the louver blade 52. The louver blades 52 of the louver support 50 can be arranged aligned with each other (also see Figs 3A, 5A, 5B). The louver blades 52 of a louver support 50 can be arranged parallel to each other (also see Figs 3A, 5A, 5B). The louver blades 52 can be arranged such that the longitudinal extension directions L of the louver blades 52 run perpendicular to the height direction H. The louver blades 52 can be arranged such that the longitudinal extension directions L of the louver blades 52 run horizontally. In the illustrated embodiment, the louver blades 52 are arranged evenly distributed along the height direction H (equally spaced apart along the height direction H) (also see Figs 3A, 5A, 5B).

A louver blade 52 can comprise a leading edge 84 (foot edge 84). The leading edge 84 of the louver blade 52 can extend in the longitudinal extension direction L of the respective louver blade 52. The leading edges 84 of the louver blades 52 can be arranged aligned. In an embodiment, the leading edges 84 of the louver blades 52 are arranged in the louver plane P. The leading edges 84 of the louver blades 52 can span the louver plane P (also see Figs 3A, 3B, 4).

One louver blade 52, particularly each louver blade 52, can comprises an air-flow-facing surface 58. The louver blades 52 can be arranged or arrangeable such that the air-flow-facing surface 58 faces the airflow when the panel 1 is used as intended. The air-flow-facing surface 58 can be concavely curved (particularly from the leading edge towards the trailing edge).

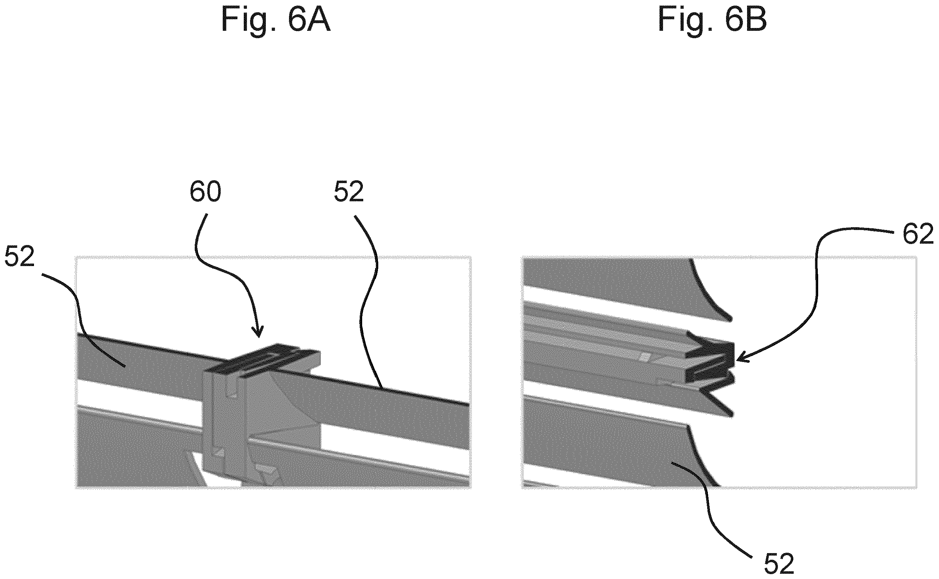

The louver support 50 can comprise an interlocking structure 60, 62 (also see Figs 6A, 6B). In an embodiment, the louver support 50 comprises a plurality of interlocking structures 60, 62. An interlocking structure 60, 62 can be arranged and configured to attach neighbouring louver supports 50. The interlocking structure 60 can be arranged and configured for horizontal attachment, such that the attached louver supports 50 are arranged side by side (row of an array 70 of louver supports 50) (also see Fig 6A). The interlocking structure 62 can be arranged and configured for vertical attachment, such that the attached louver supports 50 are arranged one above the other (column of an array 70 of louver supports 50) (also see Fig. 6B). In an embodiment, the interlocking structure 60, 62 can comprise a click-mechanism. In an embodiment, the interlocking structure 60, 62 can comprise a slide-in mechanism. In an embodiment, the interlocking structure 60, 62 can be configured for repeatedly, reversible assembly. In an embodiment, the interlocking structure 60, 62 can be configured for repeatedly, reversible disassembly.

In an embodiment, the louver support 50 comprises a further interlocking structure 64. The further interlocking structure can be configured for attachment of the louver support 50 to the structural frame 20. In an embodiment, the interlocking structure 60, 62 can be configured for attachment of the louver support 50 to the structural frame 20.

Attached (interconnected) louver supports 50 can form the array 70 of louver supports 50, particularly the array 70 of louver supports 50 each supporting a plurality of louver blades 52. In an embodiment, outer portions (particularly non-interconnected portions) of the attached louver supports 70 can form the outer perimeter 90 of the array 70.

An array 70 of louver supports 50 can comprise a plurality of equal louver supports 50. In an array 70 of louver supports 52, the louver blades 52 of all louver supports 50 of the array 70 can be arranged parallel to each other (see particularly Figs 1B, 2B). In an array 70 of louver support 52, each louver blade 52 can be equally aligned. In an embodiment, in an array 70 of louver support 52, all louver blades 52 can have the same size. In an embodiment, in an array 70 of louver support 52, all louver blades 52 can have the same shape. In an embodiment, in an array 70 of louver support 52, all louver blades 52 can face in the same direction.

The louver blades 52 can comprise a section with a curved shape in a cross-sectional side view. The louver blades 52 can comprise a plurality of section with a curved shape in a cross-sectional side view. The louver blades 52 can comprise a section with a straight shape in a cross-sectional side view. The louver blades 52 can comprise a plurality of sections with a straight shape in a cross-sectional side view. The louver blades 52 can comprise a section with a curved shape in a cross-sectional side view and a section with a straight shape in a cross-sectional side view.

The louver blades 52 can have a curved shape in a cross-sectional side view (see, e.g., Figs 2A, 4, 5A). The louver blades 52 can have a C-shape in a cross-sectional side view (see, e.g., Figs 2A, 5A). The louver blades 52 can have a buckled (angled) shape in a cross-sectional side view (see, e.g., Figs 3A, 3B). The louver blades 52 can have a blade-shape in a cross-sectional side view (see, e.g., Fig. 5B).

The louver blade 52 can comprise a leading edge portion 54. The louver blade 52 can comprise a trailing edge portion 56 (see Figs 3A, 3B, 4, 5A, 5B). The leading edge portion 54 can adjoin the trailing edge portion 56. The leading edge portion 54 can extend from the leading edge 84 of the respective louver blade 52.

In an embodiment, e.g. as illustrated in Fig. 3B, in the cross-sectional side-view, the leading edge portion 54 is shorter than the trailing edge portion 56. In its width extension direction W1, the leading edge portion 54 can be shorter than the trailing edge portion 56 in its width extension direction W2.

The leading edge portion 54 can enclose a first angle A1 with respect to the normal direction of the louver plane P. The trailing edge portion 56 can enclose a second angle A2 with respect to the normal direction N of the louver plane P. The first angle A1 can be smaller than the second angle A2. A difference between the second angle A2 and the first angle A1 can be a difference angle A3.

In case of louver blades 52 with a curved shape in a cross-sectional side view, the angles (e.g. angles A1, A2) can be considered with regard to the respective tangents (e.g. tangents T1, T2) and the normal direction N of the louver plane P. In an embodiment, the first angle A1 can be considered with regard to a tangent T1 at the leading edge 84 (and the normal direction N of the louver plane P). In an embodiment, the second angle A2 can be considered with regard to the tangent T2 at the trailing edge 86 (head edge 86) (and the normal direction N of the louver plane P). The trailing edge 86 can be arranged opposite to the leading edge 84 of the louver blade 52 (particularly see Fig. 4). The trailing edge portion 56 can comprise the trailing edge 86.

Along an extension direction from the leading edge 84 towards to trailing edge 86, the curvature of the louver blade 52 can change.

The louver blades 52 can be arranged and configured such that in the side view, the trailing edge portion 56, 56a of a first louver blade 52, 52a extends beyond the leading edge 84b of a second louver blade 52, 52b, with regard perpendicular to the normal direction N. In height direction H, the first louver blade 52, 52a and the second louver blade 52, 52b can overlap (see, e.g. Fig. 3A).

In Figure 3B an embodiment with an angled cross-sectional side view is illustrated. The leading edge portion 54 and the trailing edge portion 56 can enclose an obtuse angle A4. Particularly, the air-flow-facing surface of the leading edge portion 54 and the air-flow-facing surface of the trailing edge portion 56 can enclose the obtuse angle A4.

The louver blades 52 can be arranged and configured such that the leading edge portions 54 of the plurality of louver blades 52 are arranged in parallel. The louver blades 52 can be arranged and configured such that the trailing edge portions 56 of the plurality of louver blades 52 are arranged in parallel (see Fig. 3A, also see Figs 5A, 5B).

In Figs 5A and 5B, embodiments of louver blades 52 are illustrated. In Fig. 5A, a plurality of C-shaped louver blades 52 is illustrated. In Fig. 5B, a plurality of blade-shaped louver blades 52 is illustrated. On the left sides of Figs 5A and 5B, an exemplary orientation of the louver blades 52 for inflow of air for the air flow direction F is illustrated. On the right sides of Figs 5A and 5B, an exemplary orientation of the louver blades 52 for outflow of air for the air flow direction F is illustrated. In the inflow configuration (left) as well as in the outflow configuration (right), the air flow (along the air flow direction F) first reaches the leading edge portions 54.

In contrast to the inflow configuration, in the outflow configuration (orientation) the louver blades 52 are rotated. This can easily be established by rotating the entire louver support 50. Hence, a louver support may be used for the inflow configuration as well as for the outflow configuration. The production of louver supports 50 can be simplified.

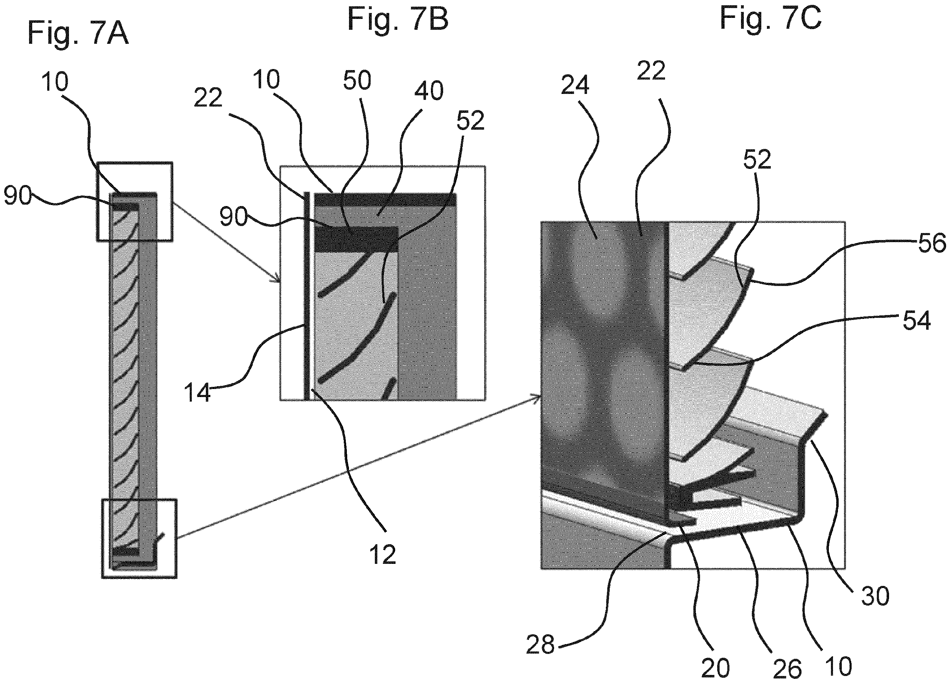

In Figs 7A to 7C, an embodiment of a structural frame 10 with an attached louver support 50 supporting louver blades 52 is illustrated. In Fig. 7A a schematic overview of the embodiment is given. Fig. 7B gives a more detailed view of the upper part of Fig. 7A. Fig. 7B gives a more detailed view of the lower part of Fig. 7A.

The structural frame 10 can comprise a metal front face 22. The metal front face 22 comprises an inner surface 12 and an outer surface 14. In an embodiment, a through-opening 24 (particularly a plurality of through-openings 24) can span the metal front face 22, particularly from the inner surface 12 to the outer surface 14. in an embodiment, the metal front face 22 can be holed (perforated). The metal front face 22 can extend in a plane.

In the illustrated embodiment, the structural frame 10 comprises an interlocking structure 20 of the structural frame 10 (Fig. 7C). In the embodiment, the interlocking structure 20 of the structural frame 10 is configured for attachment of the louver support 50, particularly via the interlocking structure of the louver support 50.

In an embodiment, the interlocking structure 20 of the structural frame 10 is arranged corresponding to the outer perimeter 90 of the louver support 50. In an embodiment, the interlocking structure 20 of the structural frame 10 is arranged corresponding to the outer perimeter 90 of the array 70 of louver supports 50.

The louver support 50 can be arranged such at the structural frame 10 that the louver plane P extends parallel to the metal front face (extension plane of the metal front plane). In the illustrated embodiment, the louver support 50 can be arranged such at the structural frame 10 that the leading edge portion 54 is arranged adjacent to the metal front face 22. In the illustrated embodiment, the louver support 50 can be arranged such at the structural frame 10 that the trailing edge portion 56 is arranged distant to the metal front face 22.

In the illustrated embodiment, the louver support 50 is arranged such at the structural frame 10 that a gap 40 between the louver support 50 and the structural frame 10. In particular, the gap 40 can be present between the louver support frame 80 and the structural frame 10. The gap 40 can be present between the outer perimeter 90 of the louver support 50 and the structural frame 10 (see Fig. 7B).

The illustrated exemplary structural frame 10 can comprise a liquid collection container 26. The liquid collection container 26 can be in fluid communication with an outlet 28. In an embodiment, via the outlet 28, liquid collected in the liquid collection container 26 can be guided out of the ventilation panel 1.

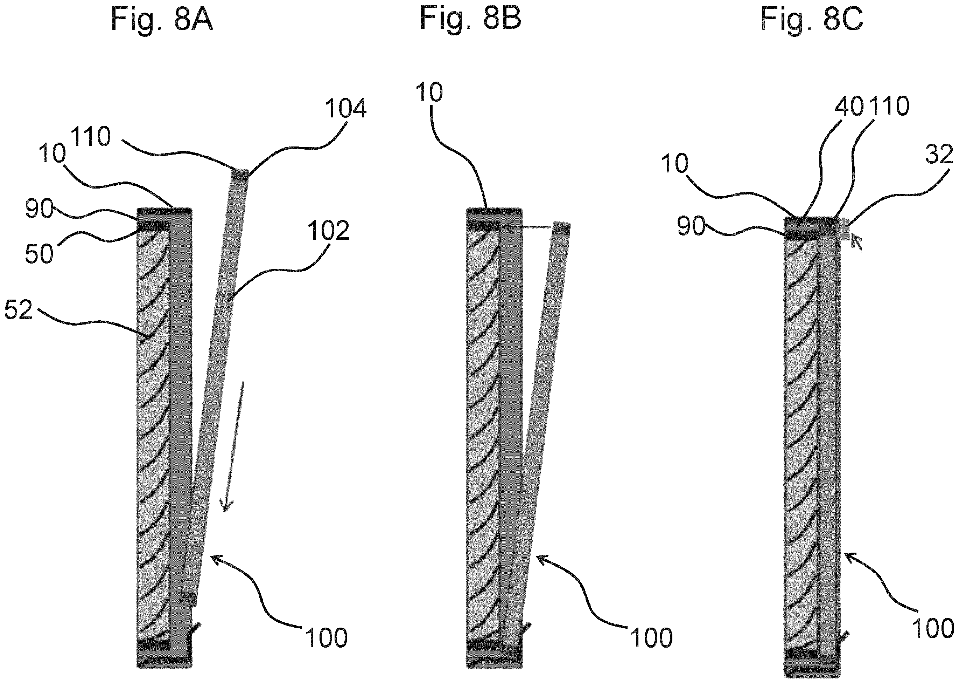

The structural frame 10 can comprise a filter installation system 30. The filter installation system 30 can be configured to receive the filter arrangement 100 (also see Figs 8A, 8B, 8C).

The filter arrangement 100 and the filter installation system 30 can be configured such that the filter arrangement 100 is insertable in the filter installation system 30. The filter arrangement 100 and the filter installation system 30 can be configured such that when the filter arrangement 100 is received by the filter installation system 30, the filter 102 of the filter arrangement 100 is arranged downstream of the louver support 50. The filter arrangement 100 and the filter installation system 30 can be configured such that when the filter arrangement 100 is received by the filter installation system 30, the filter 102 of the filter arrangement 100 is arranged downstream of the louver support 50 and the metal front face 22 of the structural frame 10. In an embodiment, when the filter arrangement 100 is received by the filter installation system 30, louver support 50 is arranged between the metal front face 22 of the structural frame 10 and the filter arrangement 100 (particularly the filter 102 of the filter arrangement 100).

In an embodiment, the filter arrangement 100 can be inserted in the filter installation system 30 (Fig. 8A) and then pushed towards the louver support 50 (Fig. 8B). The filter arrangement 100 can be fixed to the structural frame 10 (Fig. 8C).

In an embodiment, in the fully assembled state (louver support 50 and filter arrangement 100 attached to the structural frame), the louver plane P, the filter extension plane and the plane in that the metal front face extends extend in parallel. In an embodiment, in the fully assembled state, the filter extension plane and the plane in that the metal front face extend, extend perpendicular to the normal direction of the louver plane P.

In an embodiment, the filter 102 can be configured such that in the fully assembled state, the filter 102 aligns with the louver blade area 53. In an embodiment, the filter 102 can be configured such that in the fully assembled state, the filter 102 is arranged downstream of the plurality of louver blades 52. In an embodiment, the filter support 104 can be configured such that in the fully assembled state, the filter support 104 is arranged aligned with the louver support frame 80.

In an embodiment, the filter arrangement 100 can be fixed to the structural frame 10 and/or the louver support 50 by means of a fastening device 32.

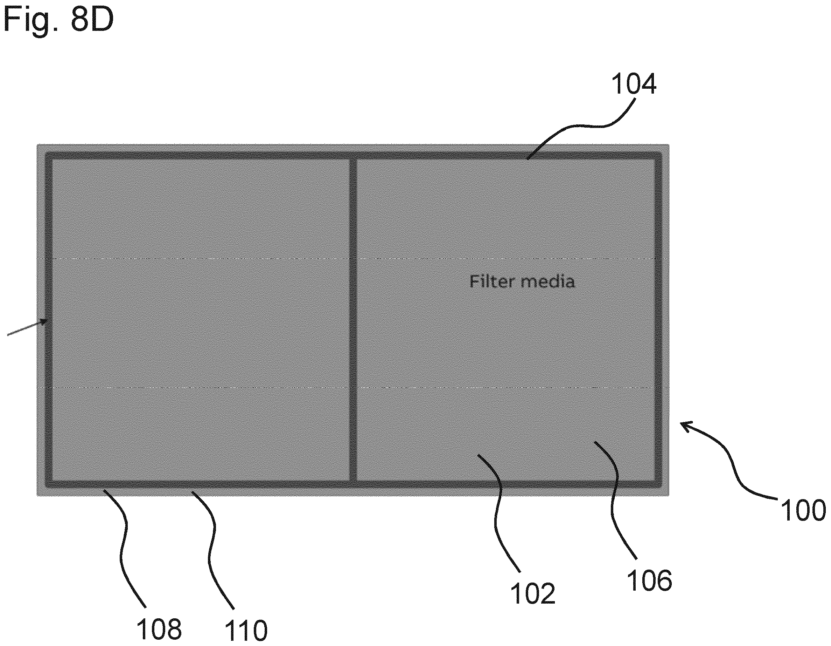

The filter arrangement 100 can comprise an outer perimeter 110 (also see Fig. 8D). The filter arrangement 100, the louver support 50 and the structural frame 10 can be configured such that in the fully assembled state, the outer perimeter 110 of the filter arrangement 100 extends outward beyond the outer perimeter 90 of the louver support 50. In an embodiment, in the fully assembled state, the outer perimeter 110 of the filter arrangement 100 can extend towards the structural frame 10. In an embodiment, the outer perimeter 110 of the filter arrangement 100 can cover the gap 40.

In an embodiment, the filter 102 can extend outwards beyond the filter support 104 (see Figs 8A, 8B, 8C, 8D, 10, 11, 12B, 13B). In an embodiment, the filter 102 can protrude outwards from the filter support 104. In an embodiment, the filter 102 can extend radially outwards beyond the filter support 104. In an embodiment, the filter 102 can extend radially outwards beyond the first filter frame 120 and/or the second filter frame 122.

The filter can comprise a central portion 106 and a perimetric portion 108. In an embodiment, the perimetric portion 108 can extend outwards beyond the filter support 104. In an embodiment, the central portion 106 can extend inwards beyond the filter support 104. In an embodiment, the outer perimeter 110 of the filter arrangement 100 can comprise the perimetric portion of the filter 102. In an embodiment, the outer perimeter 110 of the filter arrangement 100 consists of the perimetric portion of the filter 102. In an embodiment, the perimetric portion 108 and the central portion 106 extend in a common plane.

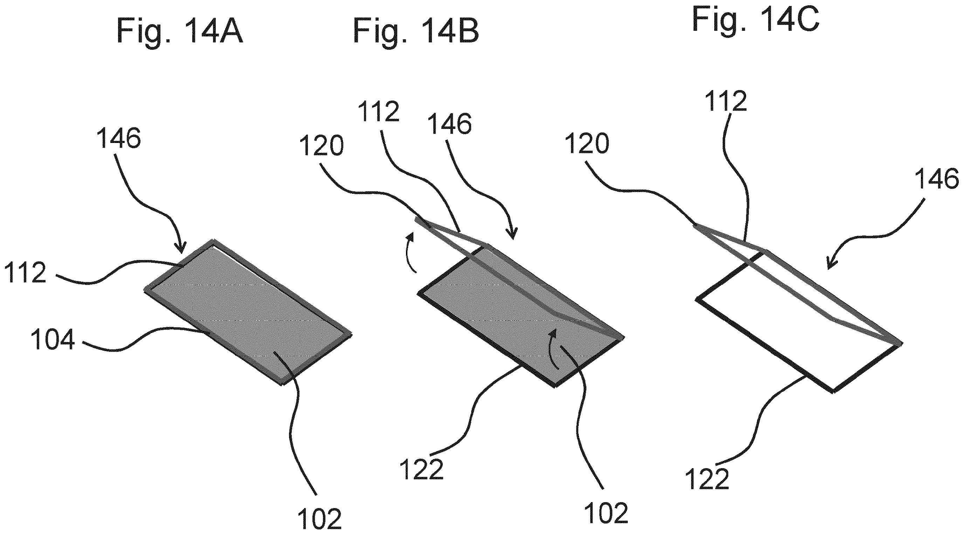

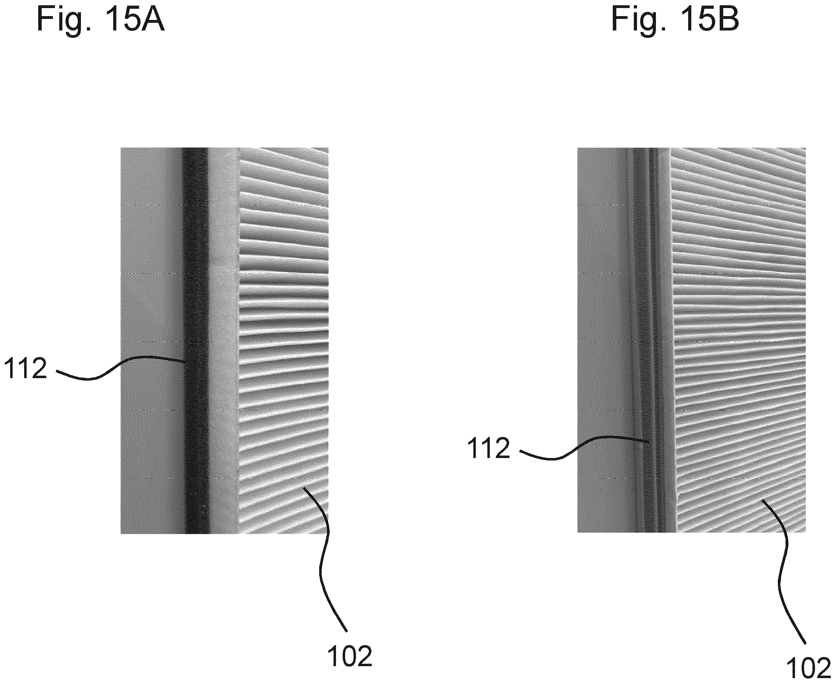

In an embodiment, the filter 102 can end in or at the filter support 104. In an embodiment, the outer perimeter 110 of the filter arrangement 100 can comprise a portion of the filter support 104 (see Figs. 14C, 15A, 15B). In an embodiment, the outer perimeter 110 of the filter arrangement 100 can comprise a portion of the filter support 104. In an embodiment, the sealing means 112 can be arranged at the filter support 104 such that the outer perimeter 110 of the filter arrangement 100 comprises the sealing means 112. The sealing means 112 can be a gasket. The sealing means 112 can be a sealing band (Fig. 15A). The sealing means 112 can be a sealing foam arranged at the filter support 104 (Fig. 15B).

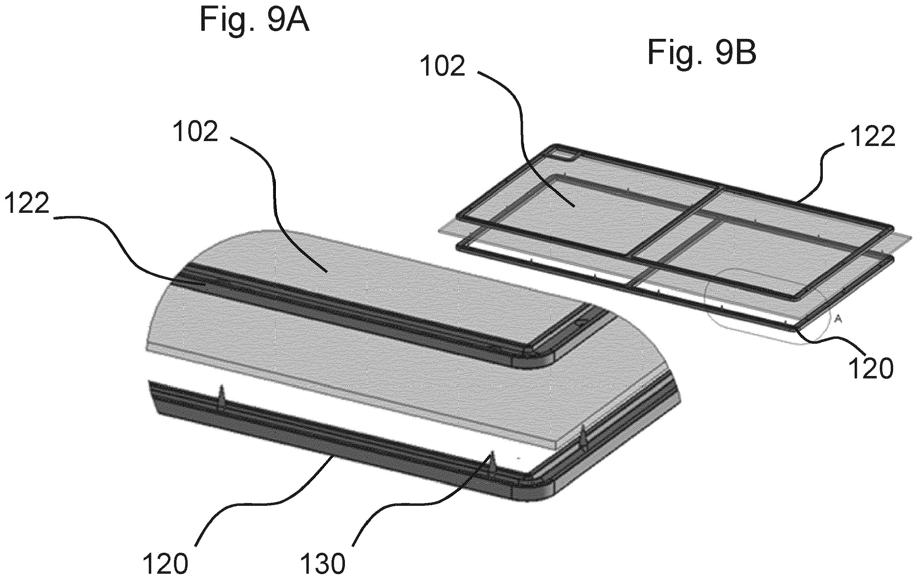

In an embodiment, the filter support 104 comprises a first filter frame 120 and a second filter frame 122 (see, Figs 9-14). The filter 102 can be fixed between the first filter frame 120 and the second filter frame 122, when the first filter frame 120 is assembled to the second filter frame 122.

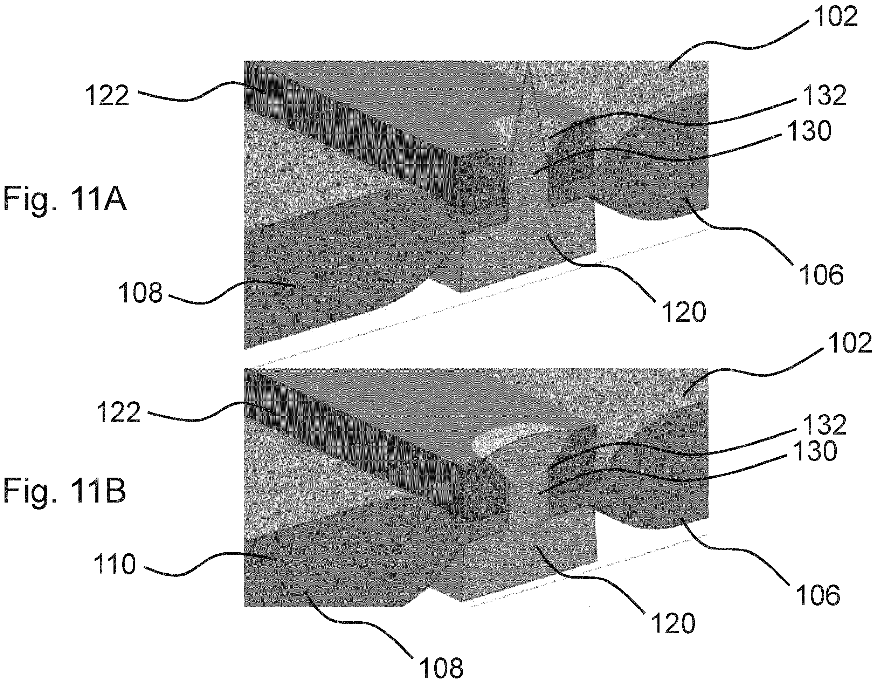

In an embodiment, the first filter frame 120 and the second filter frame 122 can be assembled (particularly with the filter 102 between) by means of a spike-and-hole mechanism (Figs 9A, 9B, 11A, 11B). The first filter frame 120 can comprise a spike 130 protruding from the first filter frame 120. The second filter frame 122 can comprise a corresponding hole 132, particularly a through-hole. The spike 130 and the hole 132 can be arranged such that they align with each other, when the first filter frame 120 and the second filter frame 122 align. The spike 130 can pierce through (penetrate) the filter 102. The spike 130 can extend through the hole 132 (Fig. 11A). In an embodiment, for fixation, the spike 130 can be melt, particularly such that the spike 130 is fastened in the hole 132 (Fig. 11B). In an embodiment, the first filter frame 120 can comprise a plurality of spikes 130 and the second filter frame 122 can comprise a corresponding plurality of corresponding holes 132.

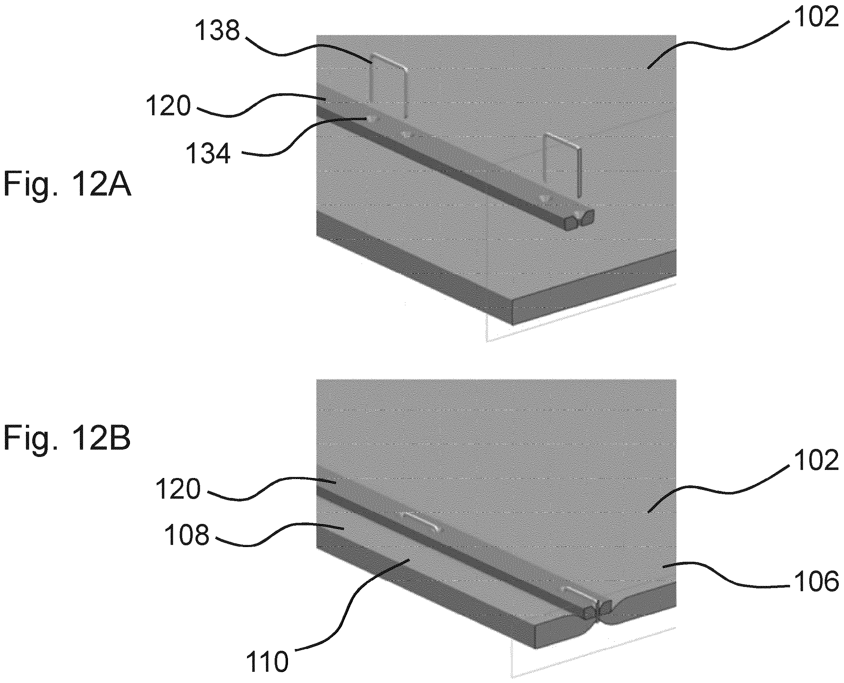

In an embodiment, the first filter frame 120 and the second filter frame 122 can be assembled (particularly with the filter 102 between) by means of a wire-mechanism (Figs 12A, 12B). The first filter frame 120 can comprise a pair of holes 134. The second filter frame 122 can comprise a further pair of holes 136. The pair of holes 134 can align with the further pair of holes 136 when the first filter frame 120 and the second filter frame 122 align. a wire 138 can be passed through the pair of holes 134. The wire 138 can be folded at the first filter frame 120 and/or the second filter frame 122. In an embodiment, the first filter frame 120 can comprise a plurality of pairs of holes 134 and the second filter frame 122 can comprise a corresponding plurality of corresponding further pairs of holes 136.

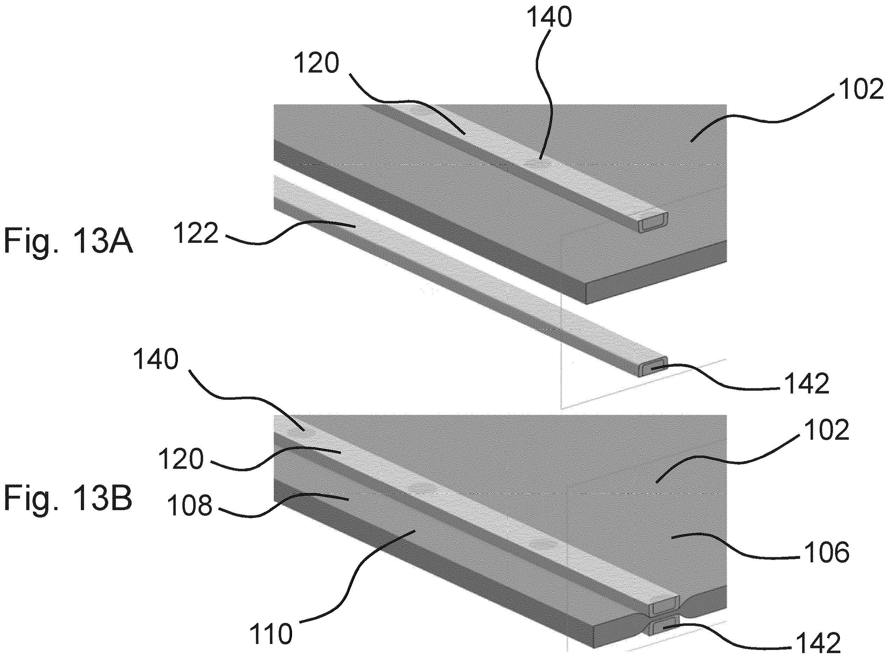

In an embodiment, the first filter frame 120 and the second filter frame 122 can be assembled (particularly with the filter 102 between) by means of a magnet-mechanism (Figs 13A, 13B). The first filter frame 120 can comprise a magnet 140, particularly an overmolded magnet. The second filter frame 122 can comprise a further magnet 142, particularly an overmolded magnet. The magnet 140 can align with the further magnet 142 when the first filter frame 120 and the second filter frame 122 align. In an embodiment, the first filter frame 120 can comprise a plurality of magnets 140 and the second filter frame 122 can comprise a corresponding plurality of corresponding further magnets 142.

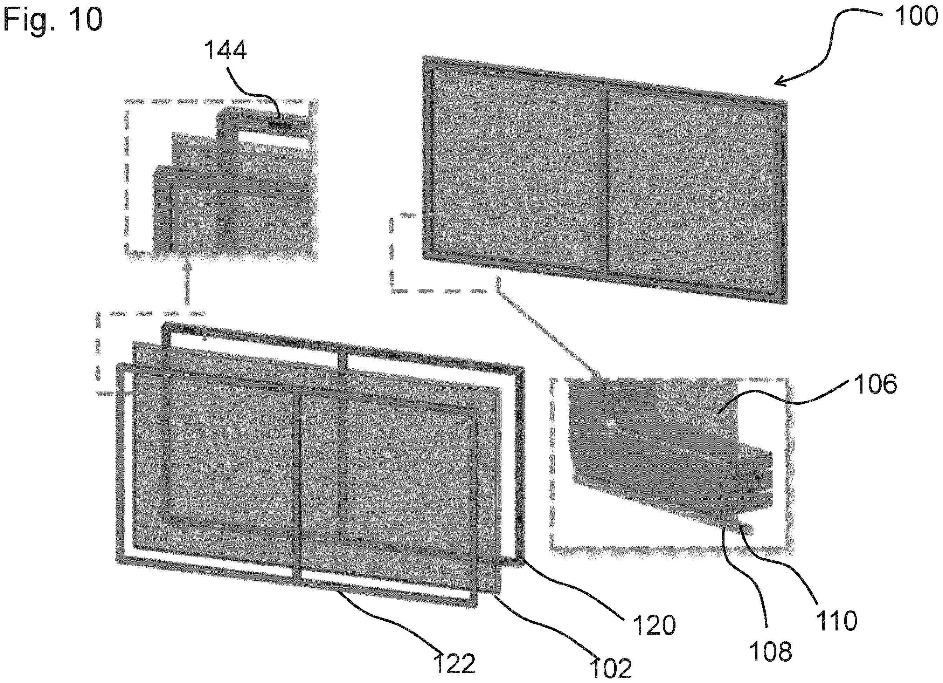

In an embodiment, the first filter frame 120 and the second filter frame 122 can be assembled (particularly with the filter 102 between) by means of a clip-mechanism (Fig. 10). The first filter frame 120 can comprise a clip 144, particularly a metal clip. The clip 144 is arranged and configured to block together the first filter frame 120 and the second filter frame 122, and particularly, the filter 102 between. The first filter frame 120 can comprise a plurality of clips 144.

In an embodiment, the first filter frame 120 and the second filter frame 122 form a hinged filter frame 146 (Fig. 14A, 14B, 14C).

The contour plot shown in Fig. 16A relates to a standard louver support. The contour plot shown in Fig. 16B relates to a louver support 50 according to an embodiment of the present invention. For the illustrated inflow condition, the plot shows a flow separation. A low velocity region 160, a high velocity region 162 and an intermediate velocity region 164 are present. A low velocity downstream the louver blade can significantly reduce the air passage, and consequently lead to an airflow acceleration.

When a filter is coupled to the standard louver, only some regions of the filters are used by the airflow, namely those one aligned with the high-velocity regions 162 (high-speed trails) coming from the louver. Hence, only some regions of the filter are used by the airflow to get out. Therefore using a standard louver is not an efficient solution, since that accelerates the airflow and leads to a restricted usage of the filter surface.

A significant aerodynamic improvement can be achieved by the louver blades 52 according to an embodiment of the invention (see Fig. 16B). The lover blades 52 (aerodynamic fins) prevent the flow separation and reduce the airflow velocity.

In Fig. 17, the normalized pressure drop across the standard and louvers according to an embodiment of the invention are shown as a function of airflow velocity. The pressure loss can be reduced for the louver blades according to the invention (compared to standard louver blades). In particular, the drop of pressure can be reduced for higher airflow velocities.

## Claims

1. A ventilation panel (1) for a charging station, particularly an electric vehicle charging station (3), wherein the ventilation panel (1) comprises
- a louver support (50), and
- a plurality of louver blades (52) supported by the louver support (50),
wherein the louver blades (52) have a sheet-like shape with a downstream trailing edge portion (56) and an upstream leading edge portion (54),
wherein the louver blades (52) have a bent shape in a cross-sectional side view,
wherein the louver blades (52) are supported by the louver support (50) such that the louver blades (52) define a louver plane (P) and a normal direction (N) being orthogonal to the louver plane (P), and that in the cross-sectional side view, the upstream leading edge portion (54) defines a smaller angle (A1) with respect to the normal direction (N) than the downstream trailing edge portion (56).

2. The ventilation panel for a charging station according to claim 1, wherein the louver blades (52) have a curved shape in a cross-sectional side view and/or wherein the louver blades (52) have an angled shape in a cross-sectional side view.

3. The ventilation panel for a charging station according to claim 1 or 2, wherein the louver blades (52) are arranged along a height direction (H) perpendicular to the normal direction (N), wherein a first louver blade (52, 52a) and a neighbouring second louver blade (52, 52b) are arranged and configured such that neighbouring pairs of louver blades overlap with each other in height direction (H).

4. The ventilation panel for a charging station according to one of the claims 1 to 3, wherein the louver blades (52) comprise a first side edge (88) connecting the leading edge (84) and trailing edge (86), wherein the louver blades (52) are mounted at the louver support (50) by the first side edge (88),
particularly wherein the louver blades (52) comprise the first side edge (88) and an opposing second side edge connecting the leading edge (84) and trailing edge (86), wherein the louver blades (52) are mounted at the louver support (50) by the first side edge (88) and the second side edge,
and/or
wherein the louver blades (52) are rotatably mounted at the louver support (50),
particularly wherein the louver blades (52) are repeatedly, reversibly rotatable between a working position and a closed position, wherein in the closed position the louver blades (52) are set at a steeper angle than in the working position, particularly such that in the closed position an air flow through the louver support (50) is reduced.

5. The ventilation panel for a charging station according to one of the claims 1 to 4, wherein the louver support (50) comprises an interlocking structure (60, 62), wherein the interlocking structure (60, 62) is configured such that a plurality of louver supports (50) are attachable to each other thereby forming a one-dimensional or a two-dimensional array (70) of interlocked louver supports (50).

6. The ventilation panel for a charging station according to one of the claims 1 to 5, wherein the ventilation panel (1) further comprises a filter arrangement (100) comprising a filter (102) supported by a filter support (104), wherein the filter (102) comprises a filter surface, and wherein the filter arrangement (100) is configured such that the filter surface is arrangeable essentially in parallel to the louver plane (P),
particularly, wherein the filter arrangement (100) and the louver support (50) are configured and arrangeable such that in an inflow configuration the trailing edge (56) is closer to the filter (102) than the leading edge (54),
and/or particularly wherein the filter arrangement (100) and the louver support (50) are configured and arrangeable such that in an outflow configuration the leading edge (54) is closer to the filter (102) than the trailing edge (56).

7. The ventilation panel for a charging station according to claim 6, wherein the filter arrangement (100) comprises an outer perimeter (110), wherein the outer perimeter (110) of the filter arrangement (100) comprises a portion of the filter (102) and/or a portion of the filter support (104), wherein the outer perimeter (110) of the filter arrangement (100) is configured for sealing.

8. The ventilation panel for a charging station according to claim 6 or 7, wherein the filter support (104) comprises a first filter frame (120) and a corresponding second filter frame (122), wherein the first filter frame (120) and the second filter frame (122) are configured such that the first filter frame (120) is assemblable to the second filter frame (122),
particularly wherein the first filter frame (120) and the second filter frame (122) are configured such that the filter (102) is mechanically locked between the first filter frame (120) and the second filter frame (122), when the first filter frame (120) is assembled to the second filter frame (122).

9. The ventilation panel for a charging station according to one of the claims 6 to 8, wherein the filter support (104) comprises an attachment device, wherein the attachment device is arranged and configured to attach the filter (102) to the filter support (104),
wherein the attachment device is configured for single use,
or
wherein the attachment device is configured for repeated, reversible attachment,
particularly wherein the attachment device comprises a magnet, a clip, a hinge, a wire, a tongue, a groove, a plug and/or a socket.

10. The ventilation panel for a charging station according to one of the claims 7 to 9, wherein the filter (102) protrudes outwards beyond the filter support (104) when the filter (102) is mechanically locked between the first filter frame (120) and the second filter frame (122), such that the outer perimeter (110) of the of the filter arrangement (100) comprises the filter (102) protruding outwards beyond the filter support (104),
and/or
wherein the filter support (104) comprises a sealing means (112), particularly wherein the sealing means (112) is arranged at an outer perimeter of the filter support, such that the outer perimeter (110) of the of the filter arrangement (100) comprises the filter support (104) comprising the sealing means (112).

11. The ventilation panel for a charging station according to one of the claims 1 to 10, wherein the ventilation panel (1) for a charging station further comprises a structural frame (10), wherein the structural frame (10) comprises an outer surface (14) and an inner surface (12), wherein the structural frame (10) and the louver support (50) are configured such that the louver support (50) is arrangeable at the inner surface (12) of the structural frame (10), particularly such that the louver plane (P) is arrangeable parallel to the inner surface (12) of the structural frame (10).

12. The ventilation panel for a charging station according to claim 11, wherein the structural frame (10) comprises an interlocking structure (20) and wherein the louver support (50) comprises a corresponding interlocking structure wherein the interlocking structures are configured such that the louver support (50) is repeatedly, reversibly assemblable to the structural frame (10),
particularly wherein the interlocking structure (20) of the structural frame (10) and the interlocking structure of the louver support (50) provide a clamping interlocking system.

13. The ventilation panel for a charging station according to claim 11 or 12, wherein the structural frame (10) comprises a metal front face (22), wherein the metal front face (22) comprises a plurality of through-openings (24), and/or wherein the structural frame (10) comprises a liquid collection container (26), wherein the liquid collection container (26) is in fluid communication with an outlet (28).

14. The ventilation panel for a charging station according to one of the claims 11 to 13, wherein the structural frame (10) comprises a filter installation system (30), wherein the filter installation system (30) is configured to receive the filter arrangement (100), wherein the filter installation system (30) is arranged and configured such that when the louver support (50) is assembled to the structural frame (10) and the filter arrangement (100) is received by the filter installation system (30), the outer perimeter (110) of the filter arrangement (100) provides a sealing between the structural frame (10) and the filter (102).

15. A charging station (3) comprising the ventilation panel (1) according to one of the claims 1 to 14, particularly wherein the ventilation panel (1) is removably installable in a ventilation opening (5) of the charging station (3).
